Europäisches Patentamt

European Patent Office

Office européen des brevets

(19)

(11) Veröffentlichungsnummer: **0 342 445**
A1

(12) **EUROPÄISCHE PATENTANMELDUNG**

(21) Anmeldenummer: 89108092.1

(51) Int. Cl.⁴: **G01R 27/04**

(22) Anmeldetag: 05.05.89

(30) Priorität: 18.05.88 CH 1878/88

(43) Veröffentlichungstag der Anmeldung:
23.11.89 Patentblatt 89/47

(84) Benannte Vertragsstaaten:
**CH DE FR GB LI SE**

(71) Anmelder: **ASEA BROWN BOVERI AG**
**Haselstrasse**
**CH-5401 Baden(CH)**

(72) Erfinder: **Garbe,Heyno, Dr.**
**Im Rüteli 7**
**CH-5405 Baden(CH)**
Erfinder: **Hansen, Diethard, Dr.**
**Bahnhofstrasse 39a**
**CH-8965 Berikon(CH)**

(54) **Anordnung zum Messen von Transferimpedanzen.**

(57) Bei einer Anordnung zum Messen von Transferimpedanzen von koaxialen Systemen (3) wird ein Generator (1) über ein koaxiales, speisendes System (2) an einen Leiterschirm (6) des koaxialen Systems (3) an einem ersten Ende des koaxialen Systems (3) angeschlossen. Ein Spannungsmessgerät wird am ersten Ende zwischen Leiterschirm (6) und Innenleiter (5) des koaxialen Systems (3) angeschlossen. Der elektrische Kontakt zwischen speisendem System (2) und Leiterschirm (6) wird durch eine Spannzange (12) geschaffen. Der Leiterschirm (6) und der Innenleiter (5) sind an einem zweiten Ende des koaxialen Systems (3) kurzgeschlossen.

FIG.2

EP 0 342 445 A1

## ANORDNUNG ZUM MESSEN VON TRANSFERIMPEDANZEN

### TECHNISCHES GEBIET

Die Erfindung betrifft eine Anordnung zum Messen von Transferimpdanzen von koaxialen Systemen, umfassend einen Generator, welcher über ein koaxiales, speisendes System an einen Leiterschirm des koaxialen Systems an einem ersten Ende des koaxialen Systems angeschlossen ist, und ein Spannungsmessgerät, welches am ersten Ende zwischen Leiterschirm und Innenleiter des koaxialen Systems angeschlossen ist.

### STAND DER TECHNIK

Im Hinblick auf den Entwurf von Systemen, die den Anforderungen der elektromagnetischen Verträglichkeit (EMV) gerecht werden, ist es wichtig, das Einkopplungsverhalten von transienten, nicht sinusförmigen Signalen in elektrische Leiter, insbesondere in geschirmte Koaxialkabel, vorhersagen zu können. Neben der Amplitude, muss auch die Phase der Transferimpedanz bekannt sein.

Die Norm IEC-96-1A gibt ein Verfahren an, um im Frequenzbereich die Amplitude der Transferimpedanz zu messen. Die Vorschriften zum Durchführen des Verfahrens sind jedoch nur für nicht allzu hohe Frequenzen (bis ca. 30 MHz) gut zu realisieren. Entsprechend haben sich die Messungen bisher vorwiegend auf diesen Freugenzbereich begrenzt.

Ein Problem bei dieser Norm stellt die geforderte Lötverbindung zwischen speisendem System und Kabelschirm dar. In der Praxis zeigt sich, dass es schwierig ist, eine gute Lötverbindung zu schaffen, ohne das Kabeldielektrikum zu beschädigen oder den Leiterschirm zu verändern (Eindringen von Lötzinn durch das Schirmgeflecht). Ein weiteres Problem stellt der geforderte angepasste Kabelabschluss dar. Erstens sind Widerstände frequenzabhängig (d.h. die Anpassung ist nur in einem bestimmten Frequenzbereich gegeben) und zweitens besteht zwischen Widerstand und Kabel beim Montieren vielfach eine Lücke, welche zu einem inhomogenen Leitungsstück führt. Dies ist insbesondere für den höheren Frequenzbereich zu vermeiden, da die von der Norm angegebene Korrekturformel ein homogenes Leitungsstück voraussetzt. Aus dem selben Grund ist es auch wichtig, dass das Kabel koaxial verläuft, was aber bei der Norm IEC-96-1A nicht ohne Schwierigkeiten einzuhalten ist.

All die beschriebenen Nachteile des Standes der Technik haben zur Folge, dass man sich bei den Messungen vorwiegend auf einen Frequenzbereich begrenzt hat, in welchem die Leitung gegenüber der Wellenlänge als klein gelten kann.

### DARSTELLUNG DER ERFINDUNG

Aufgabe der Erfindung ist es, eine Anordnung zum Messen von Transferimpedanzen von koaxialen Systemen, umfassend einen Generator, welcher über ein koaxiales, speisendes System an einen Leiterschirm des koaxialen Systems an einem ersten Ende des koaxialen Systems angeschlossen ist, und ein Spannungsmessgerät, welches am ersten Ende zwischen Leiterschirm und Innenleiter des koaxialen Systems angeschlossen ist, anzugeben, welches einfach ist, d.h. mit geringem Aufwand reproduzierbare Resultate liefert und besonders auch für höhere Frequenzen problemlos anwendbar ist.

Erfindungsgemässe besteht die Lösung darin, dass der elektrische Kontakt zwischen speisendem System und Leiterschirm durch eine Spannzange geschaffen wird und dass der Leiterschirm und der Innenleiter an einem zweiten Ende des kaoxialen Systems kurzgeschlossen sind.

Bei einer bevorzugten Ausführungsform ist das speisende System ein Rohr, welches an einem Ende eine Gewindekappe aufweist, in welcher die Spannzange fixiert wird. Das Rohr hat über die ganze Länge einen konstanten Innendurchmesser.

Besonders praktisch ist es, wenn das Rohr an beiden Enden mit einer Gewindekappe abgeschlossen ist.

### KURZE BESCHREIBUNG DER ZEICHNUNG

Nachfolgend soll die Erfindung anhand von Ausführungsbeispielen und im Zusammenhang mit der Zeichnung näher erläutert werden. Es zeigen:

Fig. 1 eine Messanordnung nach Norm IEC-96-1A;

Fig. 2 eine erfindungsgemässe Anordnung zum Messen von Amplitude und Phase von Transferimpedanzen;

Fig. 3 eine Gewindekappe mit einer Spannzange;

Fig. 4 einen Querschnitt durch eine Spannzange mit einem eingeklemmten Koaxialkabel;

Fig. 5 einen gemessenen Frequenzgang eines Kabels (RG 58 C/U) und

Fig. 6 eine Korrelationskurve der erfindungsgemässen Anordnung.


WEGE ZUR AUSFÜHRUNG DER ERFINDUNG


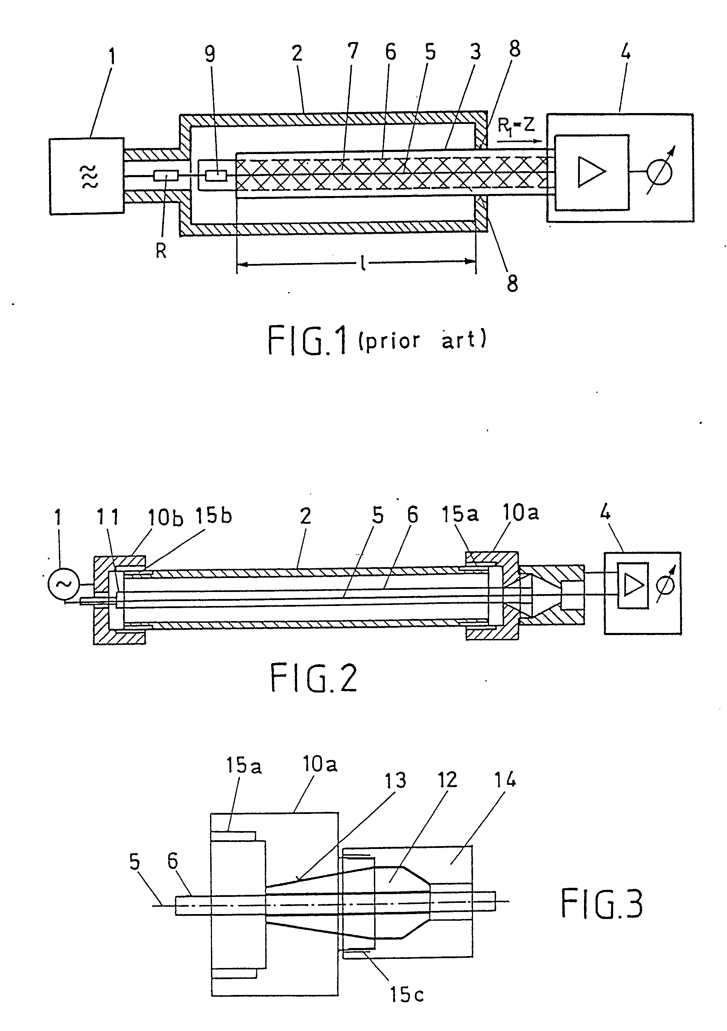

Zum besseren Verständnis soll vorerst nochmals kurz die Anordnung der Norm IEC-96-1A diskutiert werden. Fig. 1 zeigt die Anordnung zum
Messen von Transferimpedanzen. Untersucht wird
ein koaxiales System 3, z.B. ein geschirmtes Kabel. Es umfasst einen koaxialen Innenleiter 5, einen
Leiterschirm 6 und ein Dielektrikum 7, welches
Leiterschirm 6 und Innenleiter 5 isoliert.

Ein Generator 1 ist über ein koaxiales, speisendes System 2 an einem ersten Ende des koaxialen
Systems 3 an den Leiterschirm 6 angelötet
(Lötstelle 8). An einem zweiten Ende ist der Innenleiter 5 mit einem angepassten Widerstand 9 abgeschlossen und dann am Leiterschirm 6 angeschlossen. Dieses abgeschlossene zweite Ende ist über
einem Widerstand mit dem Generator 1 verbunden.

Ein Spannungsmessgerät 4 misst am ersten
Ende die Amplituden zwischen Leiterschirm 6 und
Innenleiter 5.

Fig. 2 zeigt eine bevorzugte Ausführungsform
der Erfindung. In Fig. 2 sind die zu Fig. 1 entsprechenden Teile mit gleichen Bezugszeichen versehen.

Gemäss einer bevorzugten Ausführungsform
ist das speisende System 2 ein Rohr mit einem
konstanten Innendurchmesser, welches an seinen
Enden mit je einer Gewindekappe 10a, 10b abgeschlossen ist.

Der angepasste Widerstand 9 (Fig. 1) ist erfindungsgemäss durch einen Kurzschluss 11 (Fig. 2)
ersetzt.

Die Gewindekappe 10a umfasst eine Spannzange 12, welche den gewünschten guten Kontakt
zwischen speisendem System 2 und Leiterschirm 6
schafft.

Fig. 3 zeigt nochmals die Gewindekappe 10a.
Mit einem ersten Gewinde 15a wird sie auf das
speisende System geschraubt. Sie ist mit einer
axialen, konischen Bohrung 13 versehen, in welche
die Spannzange 12 durch einen Aufsatz 14 hineingepresst wird. Zu diesem Zweck ist die Gewindekappe 10a z.B. mit einem zweiten Gewinde 15b
versehen, in welchem der Aufsatz 14 festgeschraubt wird.

Das erste Gewinde 15a ist dazu da, das koaxiale System 3 (z.B. ein Koaxialkabel) zu spannen.
In diesem Zusammenhang ist es vorteilhaft auch
am anderen Ende des speisenden Systems 2 eine
Gewindekappe 10b aufzusetzen.

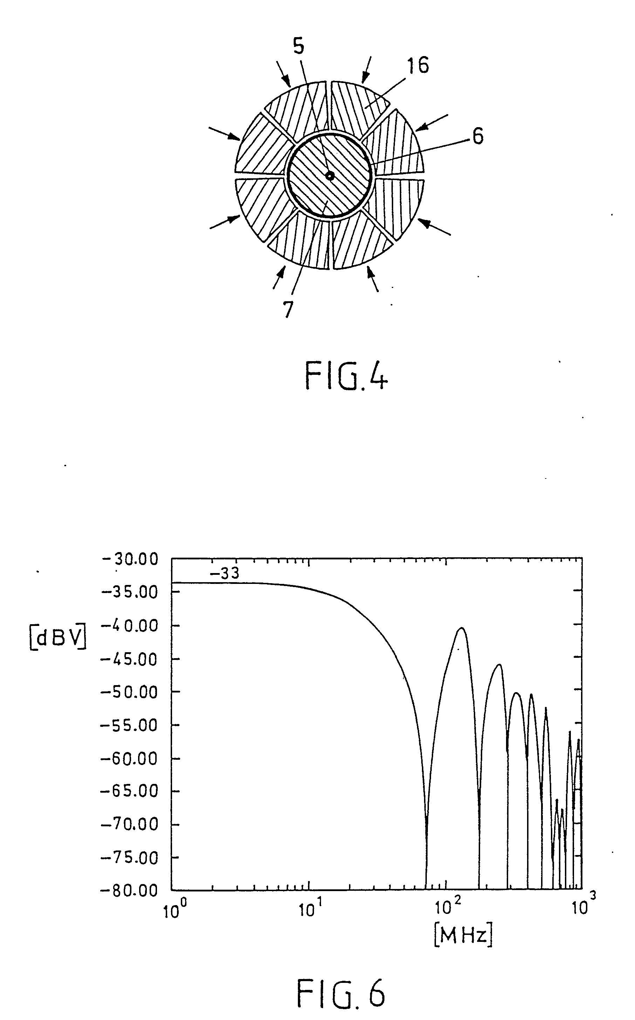

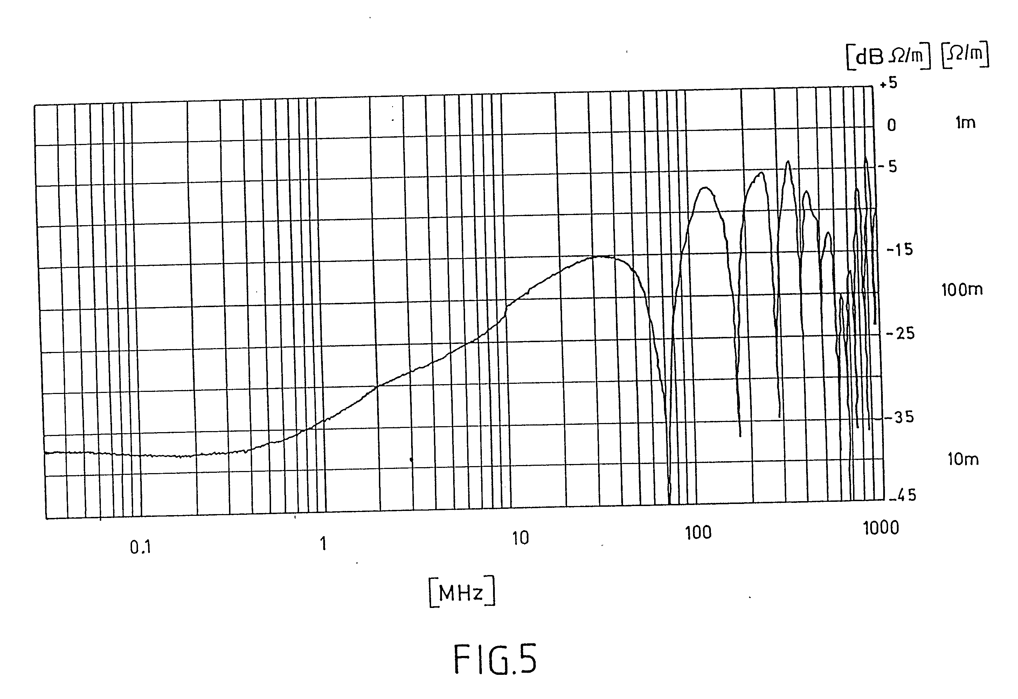

Fig. 4 zeigt einen Querschnitt durch eine Spannzange 12. Sie besteht im wesentlichen aus
einer Anzahl Segmenten 16, welche lose miteinander zusammenhängen. In der Mitte wird das koaxiale System mit dem Innenleiter 5, dem Dielektrikum 7 und dem Leiterschirm 6 eingeführt. (Eine
den Leiterschirm umgebende Schutzhülle ist vorher
entfernt worden.) Wenn der Aufsatz 14 an der
Gewindekappe 10a festgeschraubt wird, wird die
Spannzange 12 in radialer Richtung (siehe Pfeile in
Fig. 4) auf den Leiterschirm 5 gepresst. Auf diese
Weise wird ein guter Kontakt gesichert, ohne dass
das Dielektrikum 7 beschädigt oder der Leiterschirm 6 beeinflusst wird.

Für einen optimalen elektrischen Kontakt werden die Spannzange 12 und die Gewindekappe
10a vorzugsweise vergoldet.

Ein grosser Vorteil der Anordnung mit der
Spannzange liegt auch darin, dass das Kabel
schnell und leicht auszuwechseln ist.

Damit der Leiterschirm 6 mit dem speisenden
System 2 eine homogene Leitung bildet, muss das
koaxiale System 3 genau auf einer Achse des
speisenden Systems liegen. Dies wird mit den Gewindekappen 10a, 10b erreicht, mit welchem das
Koaxialkabel gespannt werden kann.

Wie bereits gesagt, wird der angepasste Widerstand 9 durch einen Kurzschluss 11 ersetzt.
Dieser ist nicht mit den bereits erwähnten Problemen behaftet. Auch die Auswertung der Messergebnisse wird dadurch nicht erschwert. Bekanntlich
müssen die Messwerte auch bei dem Verfahren
nach IEC-96-1A noch mit einer Korrelationsfunktion
für den hohen Frequenzbereich (> 30 MHz) verknüpft werden, um den Frequenzgang zu erhalten.
Bei der erfindungsgemässen Anordnung ändert
sich dann einfach die Korrelationsfunktion.

Der Kurzschluss 11 hat ausserdem den Vorteil,
dass sich die Dynamik der Messung um bis zu 6
dB erhöht. Dass die erfindungsgemässen Verbesserungen der Norm IEC-96-1A tatsächlich die erhofften Wirkungen haben, lässt sich anhand einer
Labormessung zeigen.

Fig. 5 zeigt eine Messung an einem Kabel (hier
RG 58 C/U). Auf der Abszisse ist die Frequenz in
MHz und auf der Ordinate der Messwert in dB Ω/m
aufgetragen. Die Messung ist teilkompensiert, d.h.
der konstante Anteil von -33 dBV ist bereits von
den Messwerten subtrahiert worden, um Uebereinstimmung mit bisherigen Messungen zu verdeutlichen.

Fig. 6 zeigt eine Korrelationsfunktion. Sie wird
rechnerisch ermittelt aus den Wellenwiderständen
und Ausbreitungskonstanten der Anordnung und ist
von den Messwerten zu subtrahieren, um die gewünschte Transferimpedanz $Z_T$ zu erhalten.

Aus der Theorie ist bekannt, dass die Transferimpedanz    für    niedrige    Frequenzen
(Diffusionskopplung) konstant und für höhere (Aperturkopplung) proportional zur Frequenz ist. Für die Messung von Fig. 5 und die Korrelationsfunktion von Fig. 6 bedeutet das, dass Nullstellen in der Messung nur gleichzeitig mit Nullstellen in der Korrelationsfunktion auftreten dürfen.

Dies ist in der Tat der Fall (z.B. erste Nullstelle bei etwas mehr als 70 MHz, zweite Nullstelle bei etwas weniger als 200 MHz usw.). Wenn nun die Korrelationsfunktion von der Messung subtrahiert wird, kompensieren sich die Nullstellen.

Bei einer Messung mit der erfindungsgemässen Anordnung kann also eine ähnliche Korrektur wie bei der Norm IEC-96-1A durchgeführt werden. Ferner ist es aufgrund der hohen Messgenauigkeit bei der erfindungsgemässen Anordnung möglich, die Transferimpedanz in komplexer Form zu bestimmen.

Zusammenfassend ist festzuhalten, dass es durch die Erfindung möglich wird, über transiente Einkopplungen in Kabelsystemen Aussagen zu machen.

## Ansprüche

1. Anordnung zum Messen von Transferimpedanzen von koaxialen Systemen, umfasend

    a) einen Generator (1), welcher

    b) über ein koaxiales, speisendes System (2)

    c) an einen Leiterschirm (6) des koaxialen Systems (3) an einem ersten Ende des koaxialen Systems (3) angeschloss ist,

    d) und ein Spannungsmessgerät (4), welches am ersten Ende zwischen Leiterschirm (6) und Innenleiter (5) des koaxialen Systems (3) angeschlossen ist,

dadurch gekennzeichnet, dass

    e) der elektrische Kontakt zwischen speisendem System (2) und Leiterschirm (6) durch eine Spannzange (12) geschaffen wird und dass

    f) der Leiterschirm (6) und der Innenleiter (5) an einem zweiten Ende des koaxialen Systems (3) kurzgeschlossen sind.

2. Anordnung nach Anspruch 1, dadurch gekennzeichnet, dass das speisende System (2) ein Rohr ist, welches an einem Ende eine Gewindekappe (10a) aufweist, in welcher die Spannzange fixiert wird.

3. Anordnung nach Anspruch 2, dadurch gekennzeichnet, dass das speisende System (2) im Rohr mit konstantem Innendurchmesser ist.

4. Anordnung nach Anspruch 1, dadurch gekennzeichnet, dass die Spannzange (12) und die Gewindekappe (10a) vergoldet sind.

5. Anordnung nach Anspruch 2, dadurch gekennzeichnet, dass das Rohr an beiden Enden mit einer Gewindekappe (10a, 10b) versehen ist.

FIG.1 (prior art)

FIG.2

FIG.3

88/050

FIG.4

FIG.6

FIG.5

[MHz]

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | US-A-4 425 542 (TSALIOVICH et al.) * Insgesamt * | 1 | G 01 R 27/04 |
| A | | 2,3 | |
| | --- | | |
| A | US-A-3 952 245 (MILLER) * Spalte 2, Zeile 31 - Spalte 3, Zeile 44; Figur 2 * | 1-3 | |
| | --- | | |
| A | GB-A-1 490 421 (STANDARD TELEPHONES AND CABLES LTD) * Seite 1, Zeilen 15-22; Seite 2, Zeilen 90-119; Figur 1 * | 1 | |
| | --- | | |
| A | TOUTE L'ELECTRONIQUE, Nr. 454, Mai 1980, Seiten 63-67, Paris, FR; "Etude des influences extérieures sur les liaisons coaxiales" * Seite 64, rechte Spalte, Zeilen 6-16; Figuren unten auf Seite 65 * | 1 | |
| | ----- | | RECHERCHIERTE SACHGEBIETE (Int. Cl.4) |
| | | | G 01 R H 01 R |

Der vorliegende Recherchenbericht wurde für alle Patentansprüche erstellt

| Recherchenort | Abschlußdatum der Recherche | Prüfer |
|---|---|---|
| DEN HAAG | 10-08-1989 | WIEMANN L. |